**Europäisches Patentamt**

**European Patent Office**

**Office européen des brevets**

(19)

(11) Veröffentlichungsnummer : **0 141 276**
**B1**

(12) # EUROPÄISCHE PATENTSCHRIFT

(45) Veröffentlichungstag der Patentschrift :
**17.08.88**

(51) Int. Cl.⁴ : **F 16 L 21/08**

(21) Anmeldenummer : **84111790.6**

(22) Anmeldetag : **03.10.84**

(54) Schubgesicherte Steckverbindung für Rohre, insbesondere Muffenrohre.

(30) Priorität : **11.10.83 DE 3336855**

(43) Veröffentlichungstag der Anmeldung :
**15.05.85 Patentblatt 85/20**

(45) Bekanntmachung des Hinweises auf die Patenterteilung : **17.08.88 Patentblatt 88/33**

(84) Benannte Vertragsstaaten :
**AT CH DE FR GB IT LI SE**

(56) Entgegenhaltungen :
**EP-A- 0 073 050**
**DE-A- 2 162 435**
**DE-C- 1 817 319**
**DE-C- 2 016 440**
**DE-C- 2 205 000**
**DE-U- 1 983 876**
**DE-U- 7 931 882**
**FR-A- 1 469 580**
**FR-A- 2 351 564**
**US-A- 2 177 184**

(73) Patentinhaber : **Thyssen Industrie AG**
**Am Thyssenhaus 1**
**D-4300 Essen 1 (DE)**

(72) Erfinder : **Rammelsberg, Jürgen, Dr.-Ing.**
**Gaussstrasse 11**
**D-4690 Herne 2 (DE)**

(74) Vertreter : **Eberhard, Friedrich, Dr. et al**
**Am Thyssenhaus 1**
**D-4300 Essen 1 (DE)**

EP 0 141 276 B1

## Beschreibung

Die Erfindung betrifft eine schubgesicherte Steckverbindung für Rohre, insbesondere Muffenrohre, in deren Muffe vom Muffenende aus gesehen vor einem Dichtring eine ringförmige Ausnehmung vorgesehen ist, in der ein Verriegelungsteil angeordnet ist, das sich mit seiner als Ausschnitt einer Torusoberfläche ausgebildeten Stützfläche radial auf einer Kegelfläche und mit seiner als Zylindermantel ausgebildeten Stützfläche auf einem in die Muffe eingeführten Spitzende abstützt und das sich axial auf der Kegelfläche und an einem das Spitzende umgebenden Haltewulst abstützt, wobei die Normalen der torusausschnittförmigen Stützfläche stets die auf der Oberfläche des Spitzendes anliegende zylindermantelförmige Stützfläche schneiden.

In Druckrohren und Formstücken mit Muffenverbindungen wirken aus dem Innendruck resultierende Kräfte, die an Endpunkten, Krümmern oder Abzweigungen entweder in den umgebenden Erdboden eingetragen oder durch eine geeignete Verriegelung aufgenommen werden müssen. Für die Übertragung sehr großer Kräfte, wie sie bei Rohrleitungen großer Nennweite und bei hohen Betriebsdrücken auftreten, werden schubgesicherte Steckverbindungen eingesetzt, an denen die Kraftübertragung formschlüssig erfolgt. Dazu besitzt das in die Muffe einführbare Spitzende einen Haltewulst, meistens in der Form einer Schweißraupe, und die Muffe eine ringförmige Ausnehmung, in der mindestens ein Verriegelungsteil untergebracht ist.

Eine schubgesicherte Steckverbindung für Rohre der eingangs genannten Art ist aus DE-U-7 931 882 bekannt.

Dabei ist in der Muffe vor einem Dichtring eine ringförmige Ausnehmung vorhanden, die im wesentlichen einen rechteckigen Querschnitt hat. In der Ausnehmung sind zwei Verriegelungsteile untergebracht. Ein erstes axialinneres Verriegelungsteil, das an einer Ringschulter des eingesteckten Spitzendes sowie an dessen zylindrischer Oberfläche anliegt, hat eine als Ausschnitt einer Torusoberfläche ausgebildete Stützfläche, die ihrerseits mit einer kegelig ausgebildeten Stützfläche an einem zweiten Verriegelungsteil zusammenwirkt, das als eine im Querschnitt etwa L-förmige Kranzleiste ausgebildet ist. Die Kranzleiste stützt sich ihrerseits an der Muffe ab in der Weise, daß über eine verschließbare Einfüllöffnung eine inkompressible Masse, nämlich granulatförmige bzw. körnige Materialien, insbesondere Stahlkies oder Stahlkugeln, in den Füllraum der Ausnehmung eingebracht werden, der zwischen dem zweiten Verriegelungsteil und dem Endabschnitt der Muffe ausgebildet ist. Zum Zwecke gesicherter Inkompressibilität des Füllmaterials in der endgültigen Verlegestellung einander zugeordneter Rohrpaare ist vorgesehen, das Granulatmaterial zu schmieren und eine Druckfüllung vorzunehmen, zusätzlich Vibratoren zur Granulatverdichtung anzuwenden und mittels Schrauben, die in Gewindelöchern am die Muffe schließenden Bund geführt sind, das zweite Verriegelungsteil (die Kranzleiste) verkippbar zu machen. Es ist offensichtlich, daß bei einer derartigen Rohrverbindung ein erheblicher Montageaufwand besteht und hohe Anforderungen an die sorgfältige Arbeitsweise des Montagepersonals zu stellen sind.

Bei einer weiteren Steckverbindung (DE-C-2 205 000) wird die ringförmige Ausnehmung auf ihrem zum Muffenende hin gerichteten Abschnitt von einer Kegelfläche begrenzt und besitzt das ringförmige Verriegelungsteil eine zugeordnete Kegelfläche. Das hat den Vorteil, daß bei allen durch die Fertigung bedingten Toleranzpaarungen von Muffe und Spitzende bei genau koaxialer Anordnung der beiden zu verbindenden Rohre die Kraft über den gesamten Umfang des Verriegelungsteils gleichmäßig übertragen wird. Derartige Steckverbindungen sollen aber auch in Grenzen abwinkelbar sein. Werden die miteinander zu verbindenden Rohre abgewinkelt, dann ist eine vollflächige Anlage der beiden Kegelflächen nicht mehr möglich. Bei abgewinkelter Steckverbindung und großen Längskräften ergeben sich hohe lokale Kraft- und Spannungsspitzen, die zu einem Versagen der Schubsicherung und auch zum Einbeulen des Spitzendes führen können.

Bei anderen Steckverbindungen hat man versucht, diese Nachteile dadurch zu vermeiden, daß die kraftübertragenden Flächen der Ausnehmung und des Verriegelungsteils als Kugelflächen ausgebildet sind, die ihren gemeinsamen Mittelpunkt dort haben, wo sich bei einer Abwinklung beider Rohre deren Achsen schneiden (DE-C-1 817 319, DE-C-2 016 440, DE-C-2 162 435). Das so gebildete Kugelgelenk überträgt die Axialkraft gleichmäßig verteilt über den gesamten Muffenumfang auch bei einer abgewinkelten Rohrverbindung. Das gilt jedoch nur für Verbindungen, die exakt Nennmaße besitzen.

Die in der Praxis bei Herstellung der einzelnen Rohrverbindung zusammentreffenden Muffen und Spitzenden haben jedoch in den seltensten Fällen exakt Nennmaße. Vielfach sind solche Rohrpaare miteinander zu verbinden, die innerhalb der zulässigen Fertigungstoleranzen von den Nennmaßen abweichen. Beispielsweise können bei einer Nennweite von 500 mm Toleranzen bis zu 4 mm auftreten. Werden die Nennmaße nicht exakt eingehalten, dann verschieben sich die Mittelpunkte der Kugelflächen einerseits der Ausnehmung und andererseits des Verriegelungsteils so gegeneinander, daß die Flächenberührung durch Unterbrechungen unvollständig ist. Dabei entstehen lokale Kraft- und Spannungsüberhöhungen, die in der Lage sind, das Spitzende einzubeulen oder die Schweißraupe aus dem Spitzende herauszuschälen, wodurch die Verbindung versagt.

Aufgabe der Erfindung ist es, eine schubgesicherte Steckverbindung der eingangs beschriebenen Gattung anzugeben, die konstruktiv einfacher ausgebildet ist und demzufolge eine weniger aufwendige Montage und erhöhte Betriebssicherheit ergibt und die gleichwohl bei allen Toleranzpaarungen von Spitzende und Muffe und auch bei den üblichen Abwinklungen der Rohre unzulässige Kraft- und Spannungsspitzen vermeidet.

Diese Aufgabe wird dadurch gelöst, daß die Kegelfläche eine innere, die Ausnehmung begrenzende Wandfläche der Muffe ist und der Durchmesser des Ringquerschnittes des Torus kleiner ist als die axiale Länge der zylindermantelförmigen Stützfläche des Verriegelungsteils.

Damit wird erreicht, daß bei jeder üblichen Abwinklung und jeder üblichen Toleranz der Rohrabmessungen in der Steckverbindung die Kraft von der Muffe so auf das Spitzende des eingesteckten Rohres übertragen wird, daß die Radialkraftkomponenten zwischen dem Verriegelungsteil und der Außenfläche des Spitzendes über die zylindermantelförmige Stützfläche verteilt sind, weil Kippmomente, die überhöhte lokale Kraft- oder Spannungsspitzen hervorrufen, sicher vermieden werden. Bei üblichen Abwinklungen ist gewährleistet, daß zwischen der Kegelfläche der Muffe und der Torusfläche des Verriegelungsteils stets eine wenigstens linienförmige, durchgehend geschlossene Berührung über den Umfang vorhanden ist. Deswegen können auch im Bereich dieser Flächenpaarung keine unerwünschten Kraft- oder Spannungsspitzen auftreten.

Damit bei der axialen Abstützung des Verriegelungsteils an dem Haltewulst, der, wie bekannt, als Schweißraupe ausgebildet sein kann, keine Schälkräfte auftreten, kann das Verriegelungsteil an seiner dem Muffenrohr zugewandten Stirnseite eine dem Haltewulst zugeordnete, als Innenkegel ausgebildete Stützfläche aufweisen. Durch die Abstützung des Innenkegels auf dem Haltewulst entstehen auch radiale Kräfte, welche einem Herausschälen des Wulstes entgegenwirken.

Damit bei beanspruchter Steckverbindung das Verriegelungsteil definiert am eingeschobenen Spitzende und an dessen Haltewulst anliegt, sollte der Kegelwinkel der Kegelfläche an der Muffe kleiner als 45 Grad sein, wodurch erreicht wird, daß die auf das Verriegelungsteil einwirkenden Radialkräfte stets größer sind als die Axialkräfte. Das Verriegelungsteil kann folglich auch bei großen axialen Kräften nicht über den Haltewulst gehoben werden. Vorzugsweise besitzt die an die Torusoberfläche in Richtung auf das Muffenende anschließende Ringfläche des Verriegelungsteils eine Kontur, die bei jeder Abwinklung des Spitzendes gegenüber dem Muffenrohr im Abstand von der Kegelfläche des Muffenrohrs bleibt.

Wenn das Verriegelungsteil, wie an sich bekannt, ein federnder und geschlitzter Ring ist, der vor dem Einschieben des Spitzendes in die zugeordnete Ausnehmung eingesetzt wird, muß die von der Kegelfläche begrenzte Ausnehmung eine radiale Tiefe besitzen, die größer ist als die radiale Querschnittshöhe des Ringes (Verriegelungsteil) plus der radialen Höhe des Haltewulstes, so daß nach dem Einsetzen des Verriegelungsteils in die Ausnehmung das Spitzende mit dem Haltewulst so weit in die Muffe eingeschoben werden kann, bis der Haltewulst das Verriegelungsteil passiert hat und das Verriegelungsteil hinter dem Haltewulst sich unter Federwirkung auf das Spitzende legt.

Bei einer anderen Ausführung der Erfindung kann die Muffe ein vom Muffenende ausgehendes und sich bis in die ringförmige Ausnehmung erstreckendes Fenster aufweisen, wobei das Verriegelungsteil aus einer Mehrzahl von Verriegelungselementen besteht, deren Breite in Umfangsrichtung der Ausnehmung jeweils etwa der Breite des Fensters entspricht. Diese Ausführung hat den Vorteil, daß zunächst das Spitzende eines Rohres in die Muffe des anzuschließenden Rohres eingeführt werden kann und daß anschließend die Verriegelungselemente einzeln durch das Fenster in die Ausnehmung eingeführt und darin längs des Umfangs der Muffe verteilt werden können.

Um das Einführen und Verteilen der Verriegelungselemente zu erleichtern, kann jedes Verriegelungselement eine sich in Richtung des Spitzendes erstreckende Zunge aufweisen, die sich über das Muffenende hinaus durch einen zwischen Muffenende und Spitzende gebildeten Ringspalt erstreckt. Die Zungen können auf ihrer Oberseite wenigstens einen Vorsprung für den Ansatz eines Werkzeuges aufweisen.

Ausführungen von Schubsicherungskonstruktionen, bei welchen die Muffenverbindung zuerst montiert und danach verriegelt wird, sind bekannt. US-A-2 177 184 beschreibt eine Lösung, bei der zwei Verriegelungsklemmkeile durch zwei entsprechende Ausnehmungen in der Muffenstirn eingeführt und durch Verschieben in Umfangsrichtung festgesetzt werden. In der DE-C-2 016 440 ist eine Konstruktion dargestellt, in der zwei Verriegelungsglieder durch eine Ausnehmung in der Muffenstirn axial eingeführt und in Umfangsrichtung auf dem Spitzende in Verriegelungsstellung verschoben werden. Diese bekannten Konstruktionen besitzen den Nachteil, daß der kraftübertragende Teil des Rohrumfangs eingeschränkt und dabei zusätzlich auf nur zwei Teilbereiche des Rohrumfangs konzentriert ist. Besonders bei Rohren größerer Nennweite kommt es infolge der geschilderten Kraftflußkonzentration zu einem Versagen der Verriegelung, bevor die Wand des Rohrschaftes die Grenze ihrer Belastbarkeit erreicht hat. Um den im Bereich des Fensters unterbrochenen Kraftfluß möglichst wenig zu stören und die daraus resultierenden Folgen für die Spannungsverteilung bei belasteter Steckverbindung gering zu halten, soll nach bevorzugter Ausführung der Erfindung das Fenster einen sich in radialer Richtung erstreckenden Steg aufweisen, der zwei Teilfenster begrenzt, wobei jedes Verriegelungselement auf seiner Oberseite eine Einführungsausnehmung besitzt, deren Breite der Breite des Steges entspricht. Dieser Steg versteift die im Bereich des Fensters geschwächte Muffenwand und verhindert dadurch das Auftreten von unzulässig hohen Biegespannungen in diesem Bereich. Günstige Verhältnisse ergeben sich dann, wenn die Breite des Stegs und jeder Einführungsausnehmung etwa der Breite jedes Teilfensters entspricht.

Der Steg zwischen den beiden Teilfenstern kann auch zur Übertragung von Axialkräften herangezogen werden, wenn die Kegelfläche der Ausnehmung der Muffe lediglich im Bereich der Teilfenster unterbrochen ist und die sich an die Teilfenster anschließenden Einführungskanäle eine Höhe besitzen, die der größten radialen Tiefe der Ausnehmung entspricht. Dann können nämlich die Verriegelungselemente einzeln und nacheinander durch das Fenster in die Ausnehmung eingeschoben und darin verteilt werden. Wenn das letzte Verriegelungselement eingeschoben ist, werden alle Verriegelungselemente um ihre halbe Breite verschoben, so daß die torusausschnittförmige Stützfläche des zuletzt eingesetzten Verriegelungselementes an der auch im Bereich des Fenstersteges ausgebildeten Kegelfläche angreifen kann.

Die in die Ausnehmung eingeführten und darin verteilten Verriegelungselemente können mit einer Bandage auf dem Umfang des Spitzendes festgelegt werden.

Im folgenden werden in der Zeichnung dargestellte Ausführungsbeispiele der Erfindung erläutert ; es zeigen :

Fig. 1 teilweise einen Axialschnitt durch eine schubgesicherte Steckverbindung für Rohre,

Fig. 2 eine andere Ausführung des Gegenstandes nach Fig. 1,

Fig. 3 einen Schnitt in Richtung III-III durch den Gegenstand nach Fig. 2.

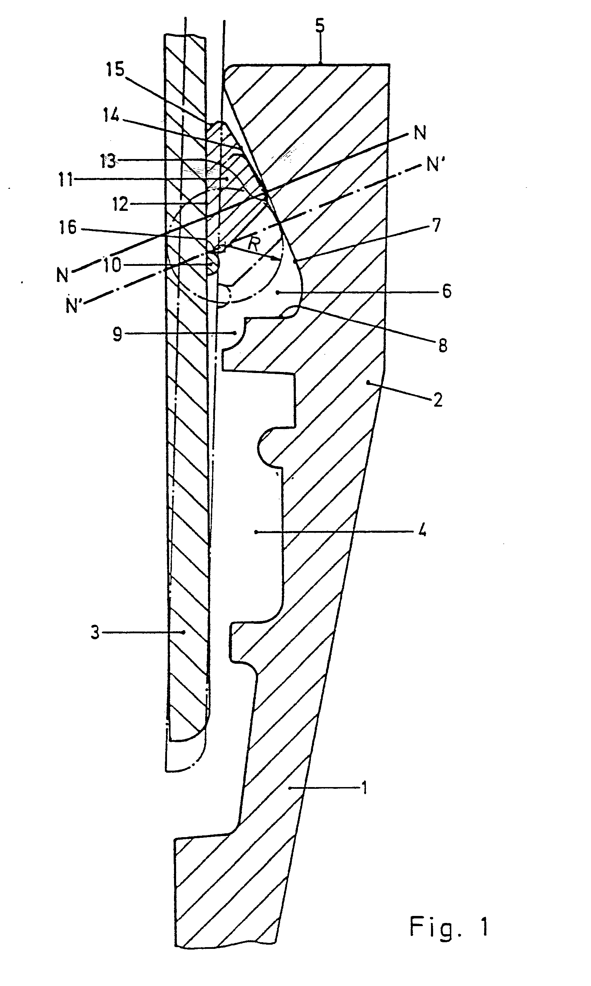

Zu der in Figur 1 dargestellten schubgesicherten Steckverbindung gehört ein Muffenrohr 1 mit Muffe 2 und das Spitzende 3 eines in die Muffe 2 einzusteckenden Rohres. Die Muffe 2 weist in einigem Abstand vom Muffenende eine ringförmige Ausnehmung 4 auf, in der ein nicht dargestellter Dichtungsring untergebracht ist, der mit dem Spitzende 3 dichtet.

Die Muffe 2 weist vom Muffenende 5 aus gesehen vor der Ausnehmung 4 für den Dichtring eine weitere ringförmige Ausnehmung 6 auf, deren zum Muffenende 5 hin gerichteter Abschnitt von einer Kegelfläche 7 begrenzt ist. Der auf die Achse des Muffenrohrs 1 bezogene Kegelwinkel der Kegelfläche 7 ist kleiner als 45 Grad und liegt z. B. für die Rohrnennweite NW 800 vorzugsweise im Bereich von 20 bis 25 Grad. Diese Ausnehmung 6 wird zum Dichtring hin von einer ringförmigen Anschlagfläche 8 begrenzt, die radial innenseitig eine umlaufende Nut 9 aufweist.

Auf das Spitzende 3 ist in einigem Abstand von seiner Stirnseite als Haltewulst 10 eine Schweißraupe aufgetragen.

Als Schubsicherung dient ein Verriegelungsteil 11, welches bei der dargestellten Ausführung ein geschlitzter und federnder Ring ist. Das Verriegelungsteil 11 weist eine als Zylindermantelfläche ausgebildete Stützfläche 12 auf, mit der es bei zusammengefügter Steckverbindung auf dem Außenumfang des Spitzendes 3 aufliegt. Es besitzt ferner eine mit der Kegelfläche 7 zusammenwirkende Stützfläche 13, die als Ausschnitt aus einer Torusoberfläche ausgebildet ist. Die in Richtung auf das Muffenende 5 an die torusausschnittförmige Stützfläche 13 anschließende Ringfläche 14 des Verriegelungsteils 11 besitzt eine Kontur, die bei jeder Abwinklung des Spitzendes 3 gegenüber dem Muffenrohr 1 im Abstand von der Kegelfläche 7 der Muffe 2 bleibt. Bei der in Figur 1 dargestellten Ausführung ist die Ringfläche 14 als eine Kegelfläche ausgebildet, deren (auf die Längsachse der Muffe 1 bezogener) Kegelwinkel jedoch größer ist als der Kegelwinkel der Kegelfläche 7.

Die dargestellte Steckverbindung wird wie folgt montiert : In das offene Muffenrohr bzw. in dessen Ausnehmung 6 wird zunächst das Verriegelungsteil 11 eingesetzt. Dann wird das anzuschließende Rohr mit seinem Spitzende 3 eingeschoben. Beim Einschieben des Spitzendes 3 gleitet zunächst die zylindermantelförmige Stützfläche 12 des Verriegelungsteils 11 über die Oberfläche des Spitzendes, bis das Verriegelungsteil 11 auf den Haltewulst 10 trifft. Eine als Innenkegel ausgebildete ringförmige Gleitfläche 15 am Verriegelungsteil 11 ermöglicht es, daß das Verriegelungsteil 11 am Haltewulst 10 aufgleitet und der Haltewulst 10 unter dem Verriegelungsteil 11 hindurchgeschoben wird. Dabei stützt sich das Verriegelungsteil 11 an der Anschlagfläche 8 der Ausnehmung 6 ab, bis der Haltewulst 10 in die Nut 9 gelangt. Dann kann das Verriegelungsteil 11 auf die Oberfläche des Spitzendes 3 zurückfedern. Wenn nunmehr das Spitzende 3 in Richtung auf das Muffenende 5 zurückgezogen wird, wird die in Figur 1 mit ausgezogenen Linien dargestellte Position erreicht, bei der sich der Haltewulst 10 an einem Innenkegel 16, dessen auf die Rohrachse bezogener Kegelwinkel ca. 85 Grad beträgt, abstützt, während die torusausschnittförmige Stützfläche 13 sich an der Kegelfläche 7 abstützt. Die dargestellte Position entspricht auch der Betriebsstellung bei koaxialer Lage von Muffe 2 und Spitzende 3 des eingesteckten Rohres.

Wie es die ausgezogenen Linien erkennen lassen, ist das Muffenrohr 1 und das Spitzende 3 miteinander fluchtend angeordnet. Die strichpunktierten Linien zeigen demgegenüber eine Position, bei der das Muffenrohr 1 und das Spitzende 3 um einen Winkel von ca. 2 Grad gegeneinander abgewinkelt sind. Man erkennt daß in allen Positionen eine zumindest linienförmige Berührung zwischen der torusausschnittförmigen Stützfläche 13 am Verriegelungsteil 11 und der Kegelfläche 7 der Ausnehmung 6 vorhanden ist. Da außerdem die torusausschnittförmige Stützfläche 13 am Verriegelungsteil 11 so angeordnet und der Kegelwinkel der Kegelfläche 7 so ausgelegt ist, daß alle Normalen der torusausschnittförmigen Stützfläche 13, — in Fig. 1 sind zwei Normalen N,N' dargestellt — die zylindermantelförmige, an der Oberfläche des Rohr-Spitzendes 3 anliegende Stützfläche 12 des Verriegelungsteils 11 schneiden, sind einerseits die in radialer Richtung auf das Verriegelungsteil wirkenden Kräfte immer größer als die axialen Kräfte und können diese Kräfte andererseits am Verriegelungsteil 11 keine Kippbewegungen hervorrufen. In Fig. 1 ist weiterhin strichpunktiert dargestellt der axiale Torusquerschnittkreis R, aus dem die Stützfläche 13 des Verriegelungsteils 11 am abgewinkelten Rohr-Spitzende 3 ein Ausschnitt ist.

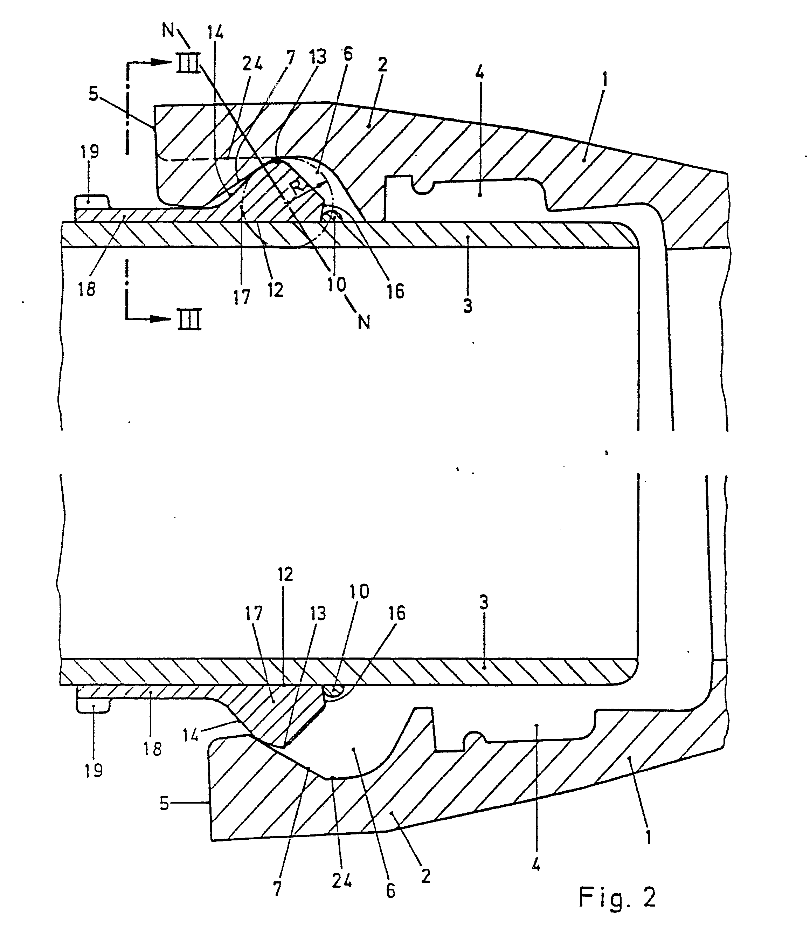

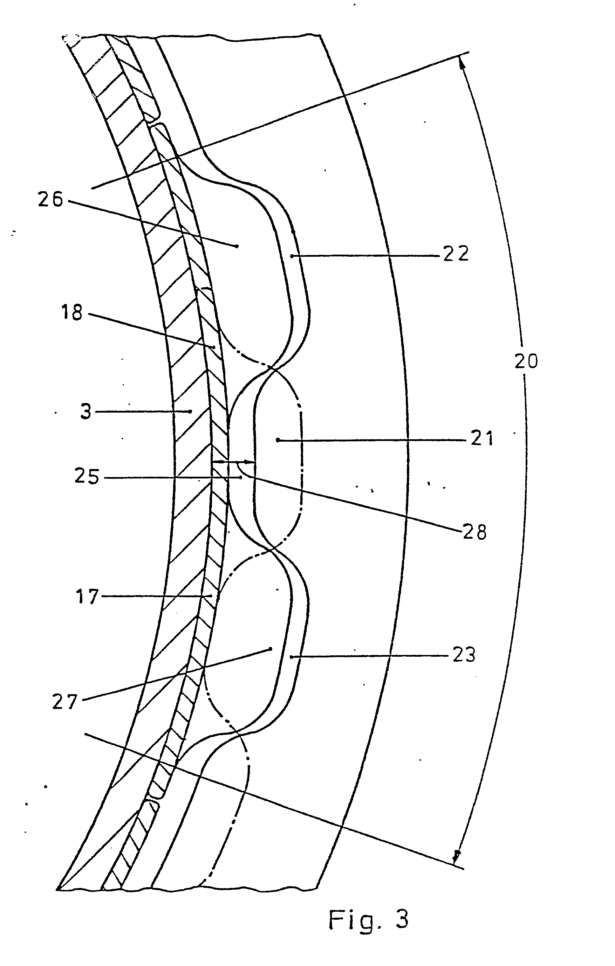

Bei der in den Figuren 2 und 3 dargestellten Ausführung bezeichnen gleiche Bezugzeichen gleiche Teile.

Anders als bei der in der Figur 1 dargestellten Ausführung ist das Verriegelungsteil nicht einstückig, sondern es besteht aus mehreren Verriegelungselementen 17, die sich jeweils über ein Achtel des Außenumfangs des Spitzendes 3 erstrecken. Die den ringförmigen Ausschnitt aus einem Torus mit dem Kreisquerschnitt R bildende, mit der Kegelfläche 7 zusammenwirkende Stützfläche 13 hat zusammen mit der Ringfläche 14 der Verriegelungselemente 17 im axialen Schnitt eine S-förmige Kontur. Der axiale Querschnittskreis R des Torus ist in Fig. 2 strichpunktiert dargestellt. Jedes Verriegelungselement 17 besitzt eine sich in Richtung des Muffenendes 5 und über dieses hinaus erstreckende Zunge 18, deren Unterseite auf der Oberfläche des Spitzendes 3 aufliegt und damit die zylindermantelförmige Stützfläche 12 vergrößert. Die Zungen 18 weisen auf ihrer Oberseite wenigstens einen Vorsprung 19 auf, der gegebenenfalls zum Ansatz eines Werkzeuges eingerichtet sein kann, mit dem die Verriegelungselemente 17 in Umfangsrichtung in der Ausnehmung 6 bewegt werden. Außerdem erstrecken sich die Zungen 18 so weit über das Muffenende 5 hinaus, daß sie mit einer nicht dargestellten Bandage auf dem Spitzende 3 festgelegt werden können. Die Vorsprünge 19 dienen dann auch dazu, die Bandage festzulegen bzw. ein Abrutschen der Bandage zu verhindern.

Bei der in den Figuren 2 und 3 dargestellten Ausführung besitzt die Muffe 2 ein vom Muffenende 5 ausgehendes Fenster 20, welches durch einen mittigen Steg 21, der sich in radialer Richtung erstreckt, in zwei Teilfenster 22, 23 geteilt ist. Die Teilfenster 22, 23 und der Steg 21 weisen in Umfangsrichtung etwa die gleiche Breite auf. Die Breite des gesamten Fensters 20 in Umfangsrichtung entspricht einem ganzzahligen Bruchteil der Umfangslänge der ringförmigen Ausnehmung 6, im vorliegenden Fall einem Achtel, so daß insgesamt 8 Verriegelungselemente 17 in der Ausnehmung 6 untergebracht werden können.

Die Teilfenster 22, 23 besitzen in radialer Richtung eine Höhe, die etwa der Höhe der Verriegelungselemente 17 mit der torusausschnittförmigen Stützfläche 13 entspricht. An die Teilfenster 22, 23 schließen sich Einführungskanäle 24 an, die in Figur 2 mit gestrichelten Linien dargestellt sind. Die radiale Höhe der Einführungskanäle 24 entspricht im wesentlichen der radialen Höhe der Ausnehmung 6. Das bedeutet, daß die Kegelfläche 7 im Bereich der Einführungskanäle 24 unterbrochen ist. Am Steg 21 bleibt jedoch die Kegelfläche 7 erhalten.

Jedes Verriegelungselement 17 besitzt in Umfangsrichtung eine Breite, die etwa der Gesamtbreite des Fensters 20 entspricht, wie das in Figur 3 dargestellt ist. Damit die Verriegelungselemente 17 in axialer Richtung in das Fenster 20 eingeschoben werden können und durch den Steg 21 nicht behindert werden, besitzen sie an ihrer Oberseite eine sich in axialer Richtung erstreckende Einführungsausnehmung 25, so daß in diesem Bereich die Dicke der Verriegelungselemente im wesentlichen der Dicke der Zunge 18 entspricht. Beidseits der Einführungsausnehmung verbleiben dann Verriegelungsvorsprünge 26, 27, deren Querschnitt in axialer Richtung aus Figur 2 ersichtlich ist.

Die in den Figuren 2 und 3 dargestellte Steckverbindung wird wie folgt montiert : In die offene Muffe 2 wird das Spitzende 3 so weit eingeführt, bis der Haltewulst 10 ungefähr das Ende der Ausnehmung 6 erreicht. Dann werden durch das Fenster 20 nacheinander die Verriegelungselemente zunächst in axialer Richtung eingesteckt und dann in Umfangsrichtung in der Ausnehmung 6 verteilt. Wenn das letzte Verriegelungselement 17 in das Fenster 20 eingeführt worden ist, werden alle Verriegelungselemente 17 um die halbe Breite eines Verriegelungselementes 17 in Umfangsrichtung verschoben, so daß - wie in Figur 3 strichpunktiert dargestellt — ein Verriegelungsvorsprung 26 oder 27 des zuletzt eingeführten Verriegelungselementes 17 hinter den Steg 21 gelangt und sich an dem dort vorhandenen Abschnitt der Kegelfläche abstützen kann. Dann werden die Zungen 18 der Verriegelungselemente 17 mit einer nicht dargestellten Bandage am Stützende 3 festgelegt.

In Figur 2 ist eine Ausführung dargestellt, bei der im zulässigen Toleranzbereich das Muffenrohr 1 das maximale Abmaß hat, mithin speziell einerseits die Innendurchmesser des Muffenendes 5 und der Ausnehmung 6 mit Kegelfläche 7 den maximalen Sollwert aufweisen und andererseits das Spitzende 3 den minimalen Solldurchmesser besitzt. Außerdem ist eine Abwinklung von ca. 2 Grad zwischen Muffenrohr 1 und Spitzende 3 dargestellt. Man erkennt in Figur 2, daß auch hierbei die torusausschnittförmigen Stützflächen 13 der Verriegelungselemente 17 an der Kegelfläche 7 der Muffe 2 in einer durchgehenden (geschlossenen) Berührungslinie anliegen, derart, daß die dort errichteten Normalen N die zylindermantelförmige Stützfläche 12 des Verriegelungsgliedes 17 schneiden. Die Verriegelungselemente 17 können keine Kippbewegungen ausführen. Die eingangs erwähnten Überlastungen der Rohr-Steckverbindung werden zuverlässig vermieden.

Bezugzeichenliste

    1 Muffenrohr
    2 Muffe
    3 Spitzende
    4 Ausnehmung
    5 Muffenende
    6 Ausnehmung
    7 Kegelfläche
    8 Anschlagfläche

9 Nut
10 Haltewulst
11 Verriegelungsteil
12 zylindermantelförmige Stützfläche
13 torusausschnittförmige Stützfläche
14 Ringfläche
15 Gleitfläche
16 Innenkegel
17 Verriegelungselement
18 Zunge
19 Vorsprung
20 Fenster
21 Steg
22 Teilfenster
23 Teilfenster
24 Einführungskanal
25 Einführungsausnehmung
26 Verriegelungsvorsprung
27 Verriegelungsvorsprung
28 Ringspalt

**Patentansprüche**

1. Schubgesicherte Steckverbindung für Rohre, insbesondere Muffenrohre (1), in deren Muffe (2) vom Muffenende (5) aus gesehen vor einem Dichtring eine ringförmige Ausnehmung (6) vorgesehen ist, in der ein Verriegelungsteil (11 ; 17) angeordnet ist, das sich mit seiner als Ausschnitt einer Torusoberfläche ausgebildeten Stützfläche (13) radial auf einer Kegelfläche (7) und mit seiner als Zylindermantel ausgebildeten Stützfläche (12) auf einem in die Muffe (2) eingeführten Spitzende (3) abstützt und das sich axial auf der Kegelfläche (7) und an einem das Spitzende umgebenden Haltewulst (10) abstützt, wobei die Normalen (N, N') der torusausschnittförmigen Stützfläche (13) stets die auf der Oberfläche des Spitzendes (3) anliegende zylindermantelförmige Stützfläche (12) schneiden, dadurch gekennzeichnet, daß die Kegelfläche (7) eine innere, die Ausnehmung (6) begrenzende Wandfläche der Muffe (2) ist und der Durchmesser (2 × R) des Ringquerschnittes des Torus kleiner ist als die axiale Länge der zylindermantelförmigen Stützfläche (12) des Verriegelungsteils (11 ; 17).

2. Steckverbindung nach Anspruch 1, dadurch gekennzeichnet, daß das Verriegelungsteil (11 ; 17) an seiner dem Muffenrohr (1) zugewandten Stirnseite eine dem Haltewulst (10) zugeordnete, als Innenkegel (16) ausgebildete Stützfläche aufweist.

3. Steckverbindung nach einem der Ansprüche 1 oder 2, dadurch gekennzeichnet, daß der Kegelwinkel der Kegelfläche (7) an der Muffe (2) kleiner als 45 Grad ist.

4. Steckverbindung nach einem der Ansprüche 1 bis 3, dadurch gekennzeichnet, daß die an die Torusoberfläche in Richtung auf das Muffenende (5) anschließende Ringfläche (14) des Verriegelungsteils (11 ; 17) eine Kontur besitzt, die bei jeder Abwinklung des Spitzendes (3) gegenüber dem Muffenrohr (1) einen Abstand von der Kegelfläche (7) der Muffe (2) ergibt.

5. Steckverbindung nach einem der Ansprüche 1 bis 4, dadurch gekennzeichnet, daß das Verriegelungsteil (11) ein federnder und geschlitzter Ring ist und daß die von der Kegelfläche (7) begrenzte Ausnehmung (6) eine radiale Tiefe besitzt, die größer ist als die radiale Querschnittshöhe des Verriegelungsteils (11) plus der radialen Querschnittshöhe des Haltewulstes (10).

6. Steckverbindung nach einem der Ansprüche 1 bis 4, dadurch gekennzeichnet, daß die Muffe (2) ein vom Muffenende (5) ausgehendes und sich bis in die ringförmige Ausnehmung (6) erstreckendes Fenster (20) aufweist und daß das Verriegelungsteil aus einer Mehrzahl von Verriegelungselementen (17) besteht, deren Breite in Umfangsrichtung der Ausnehmung (6) jeweils etwa der Breite des Fensters (20) entspricht.

7. Steckverbindung nach Anspruch 6, dadurch gekennzeichnet, daß jedes Verriegelungselement (17) eine sich in Richtung des Spitzendes (3) erstreckende Zunge (18) aufweist, die sich über das Muffenende (5) hinaus durch einen zwischen Muffenende (5) und Spitzende (3) gebildeten Ringspalt (28) erstreckt.

8. Steckverbindung nach Anspruch 7, dadurch gekennzeichnet, daß die Zungen (18) auf ihrer Oberseite wenigstens einen Vorsprung (19) für den Ansatz eines Werkzeuges aufweisen.

9. Steckverbindung nach einem der Ansprüche 6 bis 8, dadurch gekennzeichnet, daß das Fenster (20) einen sich in radialer Richtung erstreckenden Steg (21) aufweist, der zwei Teilfenster (22, 23) begrenzt und daß jedes Verriegelungselement (17) auf seiner Oberseite eine Einführungsausnehmung (25) besitzt, deren Breite der Breite des Stegs (21) entspricht.

10. Steckverbindung nach einem der Ansprüche 6 bis 9, dadurch gekennzeichnet, daß die Breite des Steges (21) und jeder Einführungsausnehmung (25) etwa der Breite jedes Teilfensters (22, 23) entspricht.

11. Steckverbindung nach einem der Ansprüche 6 bis 10, dadurch gekennzeichnet, daß die Kegelfläche (7) der Ausnehmung (6) der Muffe (2) lediglich im Bereich der Teilfenster (22, 23) unterbrochen ist und daß die sich an die Teilfenster (22, 23) anschließenden Einführungskanäle (24) eine Höhe besitzen, die der größten radialen Tiefe der Ausnehmung (6) entspricht.

12. Steckverbindung nach einem der Ansprüche 6 bis 11, dadurch gekennzeichnet, daß die Verriegelungselemente (17) mit einer Bandage auf dem Umfang des Spitzendes (3) festgelegt sind.

**Claims**

1. Locked, plug-in connection for pipes, especially for socket pipes (1), in the socket (2) of which, in front of a sealing ring when viewed from the socket end (5), is provided an annular recess (6) in which is positioned a locking member (11 ; 17) which bears radially on a conical surface (7) with its bearing surface (13) formed as segment of a toroidal surface and bears on a spigot end (3) inserted into the socket (2) with its bearing surface (12) formed as a cylindrical jacket and which bears axially on the conical surface (7) and at a retaining bead (10) surrounding the spigot end, in which the normals (N, N') of the torus-segment-shaped bearing surface (13) always intersect the cylindrical-jacket-shaped bearing surface (12) seated on the surface of the spigot end (3), characterized in that the conical surface (7) is an internal wall surface of the socket (2) delimiting the recess (6) and the diameter (2 × R) of the annular cross-section of the torus is smaller than the axial length of the cylindrical-jacket-shaped bearing surface (12) of the locking member (11 ; 17).

2. Plug-in connection according to Claim 1, characterized in that the locking member (11 ; 17) has at its front surface facing towards the socket pipe (1) a bearing surface in the form of an internal cone (16) which is associated with the retaining bead (10).

3. Plug-in connection according to one of Claims 1 or 2, characterized in that the cone angle of the conical surface (7) at the socket (2) is less than 45 degrees.

4. Plug-in connection according to one of Claims 1 to 3, characterized in that the annular surface (14) of the locking member (11 ; 17) adjacent to the toroidal surface in the direction of the socket end (5) has a contour which results in a clearance from the conical surface (7) of the socket (2) for any misalignment of the spigot end (3) relative to the socket pipe (1).

5. Plug-in connection according to one of Claims 1 to 4, characterized in that the locking member (11) is a flexible and slotted ring and that the recess (6) delimited by the conical surface (7) has a radial depth which is greater than the radial cross-sectional height of the locking member (11) plus the radial cross-sectional height of the retaining bead (10).

6. Plug-in connection according to one of Claims 1 to 4, characterized in that the socket (2) has a window (20) which extends from the socket end (5) up to the annular recess (6), and in that the locking member consists of a plurality of locking elements (17) of which the width in the circumferential direction of the recess (6) corresponds in each case approximately to the width of the window (20).

7. Plug-in connection according to Claim 6, characterized in that each locking element (17) has a tongue (18) extending in the direction of the spigot end (3) which extends beyond the socket end (5) through an annular gap (28) between the socket end (5) and the spigot end (3).

8. Plug-in connection according to Claim 7, characterized in that the tongues (18) have on their upper sides at least one projection (19) for the application of a tool.

9. Plug-in connection according to one of Claims 6 to 8, characterized in that the window (20) has a fillet (21) extending in a radial direction which delimits the two sub-windows (22, 23), and in that each locking element (17) has on its upper surface a lead-in recess (25), the width of which corresponds to the width of the fillet (21).

10. Plug-in connection according to one of Claims 6 to 9, characterized in that the width of the fillet (21) and of each lead-in recess (25) corresponds approximately to the width of each of the sub-windows (22, 23).

11. Plug-in connection according to one of Claims 6 to 10, characterized in that the conical surface (7) of the recess (6) of the socket (2) is interrupted only in the region of the sub-windows (22, 23), and in that the lead-in channels (24) adjacent to the sub-windows (22, 23) have a height which corresponds to the greatest radial depth of the recess (6).

12. Plug-in connection according to one of Claims 6 to 11, characterized in that the locking elements (17) are secured on the circumference of the spigot end (3) with a band.

**Revendications**

1. Assemblage à emboîtement, résistant à la poussée, pour tubes, en particulier tuyaux à manchons (1) dans le manchon (2) desquels est prévu un évidement (6) annulaire devant, en partant de l'extrémité de manchon (5), un anneau d'étanchéité, et où est disposée une pièce de verrouillage (11 ; 17) qui, par sa face d'appui (13), en forme de secteur torique, s'appuie radialement sur une surface conique (7) et, par sa surface d'appui (12), en forme d'enveloppe cylindrique s'appuie sur une extrémité pointue (3) introduite dans le manchon (2) et qui s'appuie axialement sur la surface sphérique (7) et contre un bourrelet de retenue (10) entourant l'extrémité pointue, les normales (N, N') de la surface d'appui (13) en forme de secteur torique, coupant toujours la surface d'appui (12), en forme d'enveloppe cylindrique, reposant sur la surface d'extrémité pointue (3), caractérisé par le fait que la surface conique (7) est une surface de paroi intérieure du manchon (2) délimitant l'évidement et le diamètre (2 × R) de la section annulaire du tore est plus petit que la longueur axiale de la surface d'appui (12), en forme d'enveloppe cylindrique, de la pièce de verrouillage (11 ; 17).

2. Assemblage à emboîtement selon la revendication 1, caractérisé par le fait que la pièce de verrouillage (11 ; 17) présente, sur sa face de bout, tournée vers le tube à manchon (1), une surface d'appui, en forme de cone intérieur (16), associée au bourrelet de retenue (10).

3. Assemblage à emboîtement selon l'une des revendications 1 ou 2, caractérisé par le fait que l'angle au sommet de la surface conique (7) sur le manchon (2) est inférieur à 45 degrés.

4. Assemblage à emboîtement selon l'une des revendications 1 à 3, caractérisé par le fait que la surface annulaire (14) de la pièce de verrouillage (11 ; 17), qui fait suite, en direction de l'extrémité de manchon (5), à la surface torique, possède un contour qui, pour chaque écartement angulaire de l'extrémité de pointe (3) par rapport au tube à manchon (1), se trouve à une certaine distance de la surface conique (7) du manchon (2).

5. Assemblage à emboîtement selon l'une des revendications 1 à 4, caractérisé par le fait que la pièce de verrouillage (11) est une bague élastique et fendue et l'évidement, limité par la surface conique (7), possède une profondeur radiale qui est plus grande que la hauteur de section radiale de la pièce de verrouillage (11) augmentée de la hauteur de section radiale du bourrelet de retenue (10).

6. Assemblage à emboîtement selon l'une des revendications 1 à 4, caractérisé par le fait que le manchon (2) possède une fenêtre (20) partant de l'extrémité de manchon (5) et s'étendant jusque dans l'évidement annulaire (6) et la pièce de verrouillage est constituée d'une pluralité d'éléments de verrouillage (17) dont la largeur, en direction périphérique de l'évidement (6), correspond à peu près à la largeur de la fenêtre (20).

7. Assemblage à emboîtement selon la revendication 6, caractérisé par le fait que chaque élément de verrouillage (17) possède une languette (18), s'étendant en direction de l'extrémité de pointe (3), au-delà de l'extrémité de manchon (5) en passant à travers un interstice annulaire (28) formé entre l'extrémité de manchon (5) et l'extrémité de pointe (3).

8. Assemblage à emboîtement selon la revendication 7, caractérisé par le fait que les languettes (18) possèdent sur leur face supérieure au moins une saillie (19) pour la pose d'un outil.

9. Assemblage à emboîtement selon l'une des revendications 6 à 8, caractérisé par le fait que la fenêtre (20) présente une entretoise (21) s'étendant en direction radiale, qui délimite deux fenêtres partielles (22, 23) et chaque élément de verrouillage (17) possède sur sa face supérieure un évidement d'introduction (25) dont la largeur correspond à la largeur de l'entretoise (21).

10. Assemblage à emboîtement selon l'une des revendications 6 à 9, caractérisé par lê fait que la largeur de l'entretoise (21) et chaque évidement d'introduction (25) correspondent à peu près à la largeur de chaque fenêtre partielle (22, 23).

11. Assemblage à emboîtement selon l'une des revendications 6 à 10, caractérisé par le fait que la surface conique (7) de l'évidement (6) du manchon (2) est interrompu seulement dans la zone de la fenêtre partielle (22, 23) et les canaux d'introduction (24) adjacents aux fenêtres partielles (22, 23) possèdent une hauteur qui correspond à la profondeur radiale maximale de l'évidement (6).

12. Assemblage à emboîtement selon l'une des revendications 6 à 11, caractérisé par le fait que les éléments de verrouillage (17) sont fixés à la périphérie de l'extrémité de pointe (3) par un bandage.

Fig. 1

Fig. 2

26

22

18

3

25

21

28

17

23

27

20

Fig. 3